## Europäisches Patentamt

## European Patent Office

## Office européen des brevets

(11) Numéro de publication: **0 207 819**
**B1**

(12) # FASCICULE DE BREVET EUROPEEN

(45) Date de publication du fascicule du brevet:
**23.08.89**

(21) Numéro de dépôt: **86401072.3**

(22) Date de dépôt: **22.05.86**

(51) Int. Cl.⁴: **H03H 9/24,** H03H 9/12,
H03B 17/00, G02B 26/02

(54) Résonateur à matériaux non piezo electrique à grand coefficient de qualité.

(30) Priorité: **30.05.85 FR 8508087**

(43) Date de publication de la demande:
**07.01.87 Bulletin 87/2**

(45) Mention de la délivrance du brevet:
**23.08.89 Bulletin 89/34**

(84) Etats contractants désignés:
**CH DE GB LI**

(56) Documents cités:
**FR-A- 2 520 566**
**FR-A- 2 528 990**

**1982 ULTRASONICS SYMPOSIUM PROCEEDINGS, IEEE GROUP ON SONICS & ULTRASONICS, San Diego, 27-29 octobre 1982, vol. 2, pages 793-795, IEEE, New York, US; E. DIEULESAINT et al.: "Optoacoustic oscillator using a quartz resonator"**

(73) Titulaire: **ETAT-FRANCAIS représenté par le DELEGUE GENERAL POUR L'ARMEMENT (DPAG), Bureau des Brevets et Inventions de la Délégation Générale pour l'Armement 26, Boulevard Victor, F-75996 Paris Armées(FR)**

(72) Inventeur: **Dieulesaint, Eugène, 2, avenue Francis Berthier, F-94100 Saint Maur(FR)**
Inventeur: **Royer, Daniel, 11, rue Edouard Branly, 91700 Ste Geneviève des Bois(FR)**

ACTORUM AG

**Description**

Les résonateurs de qualité construits actuellement sont réalisés à partir de matériaux piézoélectriques et notamment à partir de monocristaux de quartz. Ces résonateurs à ondes de volume sont constitués essentiellement d'un cristal de quartz de coupe cristallographique et de formes convenables (bâtonnet à section rectangulaire, plaquette, lame, ...) soutenu en des points choisis pour vibrer préférentiellement sur un mode donné (flexion, élongation, mode de contour, cisaillement...). Ils sont mis en vibration par une tension électrique appliquée entre des électrodes portées par le cristal de quartz ou placées à son voisinage.

De tels résonateurs connus, qui sont de type piézoélectrique, s'avèrent d'un emploi commode du fait qu'il est possible d'exciter mécaniquement le résonateur en lui appliquant une tension électrique et qu'inversement sa vibration peut être détectée par la mesure de la tension électrique induite, mais le coefficient d'atténuation des ondes élastiques est propre au matériau utilisé (voir par exemple la demande de brevet FR-A 2 520 566).

Or, pour de nombreuses applications, il est souhaitable de disposer d'un résonateur de très haute qualité.

L'invention a précisément pour objet de réaliser un résonateur de très grande qualité, qui puisse être excité et dont la fréquence de vibration puisse être mesurée sans perturber le fonctionnement du résonateur.

Ces buts sont atteints grâce à un résonateur à matériau non piézoélectrique à grand coefficient de qualité, caractérisé en ce qu'il comprend un monocristal d'un matériau non piézoélectrique présentant une faible atténuation des ondes élastiques de volume, des moyens de support du monocristal fixés sur ce dernier en des points correspondant à des noeuds de vibration, des moyens thermiques pour provoquer directement une excitation propre du monocristal, et des moyens optiques pour détecter sans contact, les déplacements périodiques du résonateur.

Selon un exemple de réalisation, le monocristal présente la forme d'un bâtonnet vibrant en flexion.

D'autres formes, telles que des plaquettes, lames, disques sont naturellement possibles pour le monocristal.

Selon un mode particulier de réalisation, simple à mettre en oeuvre, les moyens optiques de détection des déplacements périodiques du résonateur comprennent une source de lumière émettant un faisceau, une première lentille pour faire converger le faisceau vers une partie vibrante du monocristal perpendiculairement à la direction des vibrations, une seconde lentille recevant le faisceau affecté par le mouvement du monocristal et un photodétecteur, de manière à assurer la détection des vibrations du résonateur.

Selon un autre mode de réalisation particulier, les moyens optiques de détection des déplacements périodiques du résonateur comprennent un dispositif interférométrique associé à un analyseur de spectre le faisceau du dispositif interférométrique étant appliqué à la partie vibrante du cristal, parallèlement à la direction des vibrations de celui-ci.

Divers moyens d'excitation du cristal sont possibles.

Selon un moyen particulier, au moins une mince couche d'un matériau conducteur est déposée sous forme de ruban sur une face du monocristal, des fils de connexion sont raccordés à ladite couche au niveau de noeuds de vibration du cristal, et une tension électrique périodique est appliquée entre lesdits fils de connexion pour réaliser une excitation du cristal par effet thermique Joule.

La couche conductrice est constituée par une mince couche d'un métal tel que le chrome ou le nickel, déposée par évaporation sous vide ou par pulvérisation cathodique.

Selon un autre mode de réalisation, les moyens provoquant directement une excitation propre du monocristal comprennent une source de lumière et des moyens de modulation auxquels est appliquée une tension de modulation $v_m$, pour appliquer un faisceau lumineux dont l'intensité est modulée dans une zone de vibration du cristal et assurer une excitation propre du cristal par effet photothermique.

Avantageusement, le monocristal est un monocristal d'alumine ($Al_2O_3$) encore dénommé corindon.

D'autres matériaux sont cependant utilisables tel que le YAG (grenat d'yttrium et d'aluminium) ou le YIG (grenat d'yttrium et de fer).

D'autres caractéristiques et avantages de l'invention ressortiront de la description suivante de modes particuliers de réalisation de l'invention, donnée à titre d'exemple, en référence aux dessins annexés, sur lesquels:

- la figure 1 est une vue schématique en perspective d'un résonateur formé à partir d'un barreau de matériau non piézoélectrique et excité en flexion par effet Joule,
- la figure 2 représente le schéma d'un premier dispositif de détection d'un signal représentant la vibration d'un résonateur selon l'invention,
- la figure 3 représente le schéma d'un second dispositif de détection d'un signal représentant la vibration d'un résonateur selon l'invention, ainsi que le schéma d'un dispositif d'excitation par effet photothermique,
- la figure 4 représente le schéma d'un exemple de résonateur selon l'invention monté en oscillateur, et
- la figure 5 représente la forme d'un signal d'excitation pouvant être appliqué au résonateur de la figure 1.

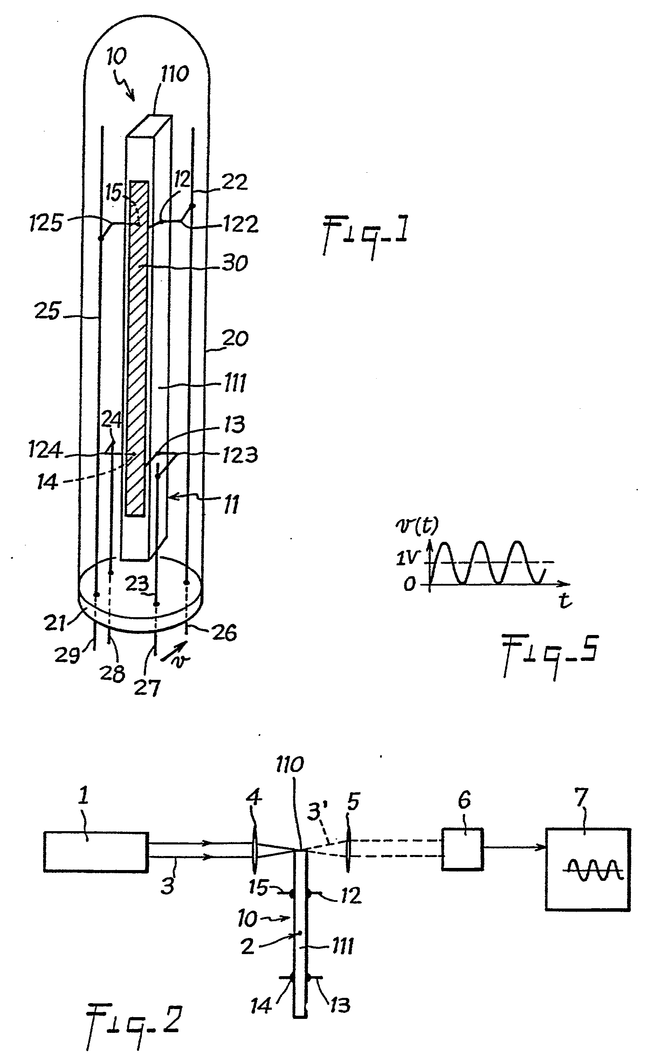

On a représenté sur la figure 1 un exemple de résonateur 10 selon l'invention, qui est placé dans une ampoule de verre 20 à l'intérieur de laquelle la pression a été abaissée. Un monocristal 11 d'un matériau non piézoélectrique à grand coefficient de qualité, par exemple un monocristal d'alumine ou un monocristal d'un grenat d'yttrium et d'aluminium (YAG) ou d'un grenat d'yttrium et de fer (YIG), se présente sous la forme d'un barreau allongé 11 supporté à l'aide de quatre tiges 22 à 25 formant des piliers fixés sur une embase isolante 21, par exemple en verre. Les tiges 22 à 25 sont prolongées à l'extérieur de l'ampoule 20, par des broches 26 à 29 respectivement. Le barreau 11 est relié aux tiges 22 à 25 par l'intermédiaire de fils coudés 122 à 125 respectivement qui sont d'une part soudés à la tige correspondante 22 à 25 et d'autre part fixés sur le barreau 11 en des points 12 à 15 qui constituent des noeuds de vibration.

Une couche conductrice 30, par exemple une mince couche de chrome ou de nickel, est déposée, par évaporation sous vide, ou par pulvérisation cathodique, sur une face du barreau 11. La couche conductrice 30 est électriquement en contact par ses extrémités à deux points 12, 13 de liaison à des tiges 22, 23 de support qui servent également de fils de connexion permettant l'application d'une tension électrique périodique entre les deux extrémités de la couche conductrice 30 qui, par effet thermique Joule, provoque une excitation du barreau 11, selon un mode de flexion dans l'exemple considéré, dans la mesure où la tension électrique v appliquée entre les broches 26, 27 reliées aux tiges 22, 23 est périodique à une fréquence qui correspond à la fréquence propre du cristal 11.

Il est avantageux, comme représenté sur la figure 5, que la tension électrique périodique d'excitation v oscille en permanence entre une valeur crête et zéro afin d'exciter le cristal 11 à la fréquence fondamentale du signal électrique. Si la tension v présentait des alternances positives et négatives, le signal électrique d'excitation devrait avoir une fréquence moitié de la fréquence propre du cristal 11.

Dans la suite de la description, on considèrera le cas d'un résonateur 10 constitué à partir d'un bâtonnet tel que celui de la figure 1, qui peut présenter par exemple une section de quelques $mm^2$ et une longueur de quelques dizaines de millimètres. Le cristal 11 pourrait cependant présenter d'autres formes, par exemple la forme d'un disque, à la manière des résonateurs à cristal piézoélectrique.

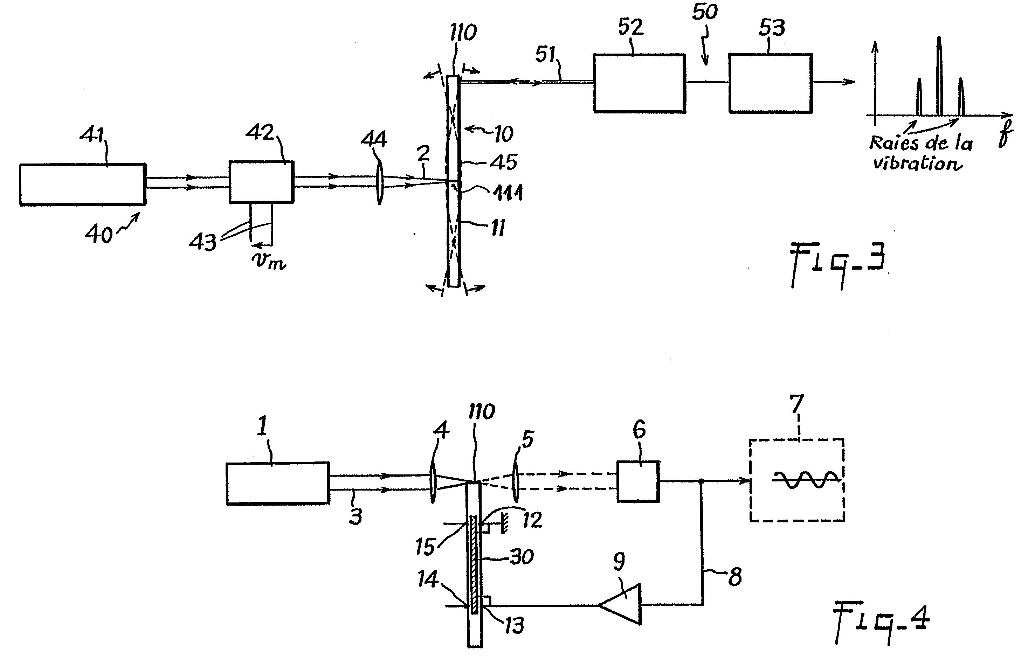

La figure 3 montre une variante de réalisation des moyens thermiques 40 d'excitation d'une partie vibrante 111 du cristal 11. Selon ce mode de réalisation, un faisceau lumineux produit par une source 41 est modulé par un modulateur 42 auquel est appliquée sur les lignes 43 une tension électrique de modulation $v_n$. Le faisceau lumineux excitateur modulé 2 issu du modulateur 42 est appliqué, par l'intermédiaire d'une lentille 44, dans une zone absorbante du cristal 11 et provoque, par effet photothermique, une dilatation périodique du cristal qui, si la fréquence du signal d'excitation $v_m$ correspond à la fréquence propre du cristal 11, fait résonner le cristal 11. L'effet d'excitation du cristal 11 peut être accru si une couche absorbante 45 est déposée sur une face du monocristal 11 dans la zone frappée par ledit faisceau lumineux modulé 2.

Si la source lumineuse 41 est un tube laser, le modulateur 42 peut être un modulateur acousto-optique. Toutefois, si la source lumineuse 41 est constituée par une diode laser, les moyens de modulation 42 peuvent être constitués directement par des moyens de modulation de la tension appliquée à la diode laser. Par ailleurs, il est préférable que le faisceau excitateur 2 soit appliqué sur une zone limitée du cristal 11, mais cette zone n'est pas nécessairement ponctuelle.

La figure 2 montre le schéma d'un résonateur 10 selon l'invention, excité par un faisceau lumineux 2 appliqué en une zone 111 du cristal 11 selon la direction des vbrations à produire, c'est-à-dire perpendiculairement au plan de la figure. Le cristal 11 est montré de façon symbolique et seuls les points de liaison 12 à 15 par lesquels le cristal 11 est rattaché au support sont représentés. Ces points correspondent à des noeuds de vibration.

Sur la figure 2, on voit un dispositif de détection comprenant une source lumineuse 1, telle qu'une source laser 1 émettant un faisceau lumineux 3 qui est appliqué par une lentille 4 sur une partie vibrante 110 du cristal 11, perpendiculairement à la direction des vibrations. Le faisceau lumineux 3' affecté par la vibration du cristal 11 est collecté par une lentille 5 et appliqué à un photodétecteur 6 délivrant un signal qui peut être observé à l'aide d'un oscilloscope 7 et représente les vibrations du cristal. Ces moyens optiques de la détection du signal de vibration sont donc particulièrement simples.

D'autres moyens optiques de détection des vibrations du cristal 11 peuvent être utilisés. Ainsi, sur la figure 3, on utilise un interféromètre 52 émettant un faisceau détecteur 51 en direction d'une partie vibrante 110 du cristal 11. Le faisceau 51 est réfléchi sur lui-même et se trouve modulé en phase par les déplacements périodiques du cristal perpendiculairement à la direction du faisceau 51 (voir les déformations en flexion du cristal 11 représentées en pointillés sur la figure 3). Le dispositif optique de détection 50 comprend en outre un analyseur de spectre 53 qui permet de mettre en évidence des raies latérales de vibration correspondant à la fréquence propre de vibration du cristal 11, dans la mesure où l'interféromètre 52 utilisé est un interféromètre hétérodyne.

Dans les cas des dispositifs des figures 2 et 3, le dispositif d'excitation 40 peut naturellement être remplacé par un dispositif d'excitation par effet Joule utilisant un ruban conducteur 30 se dilatant périodiquement à la fréquence de la tension d'excitation v, qui correspond à la fréquence de résonance du mode de flexion, comme indiqué en référence à la figure 1.

La figure 4 représente un résonateur 10 analogue à celui de la figure 2, mais excité par effet Joule et monté en boucle de façon à constituer un oscillateur. Dans ce cas, le signal électrique issu du photodétecteur 6 est réappliqué, par la ligne 8 à l'entrée d'un amplificateur 9 dont la sortie délivre la tension de modulation v appliquée aux électrodes du ruban conducteur 30.

Les rubans conducteurs 30 peuvent naturellement présenter diverses configurations adaptées à la forme du cristal 11. Dans le cas d'un barreau, il serait possible d'utiliser deux rubans conducteurs 30 déposés sur deux faces opposées du cristal 11 et excités en opposition de phase.

D'une façon similaire, lors d'une excitation à l'aide d'un faisceau lumineux partiellement absorbé dans le cristal 11 (figures 2 et 3), il est possible d'utiliser les faisceaux d'ordre zéro et d'ordre un issus d'un modulateur acousto-optique 42, qui sont en opposition de phase. Dans ce cas les faisceaux sont appliqués sur deux faces opposées du cristal 11.

A titre d'exemple, il est possible, d'obtenir des vibrations d'amplitude de l'ordre de 50 à 100 nanomètres, avec une puissance électrique d'environ10 mW dans le cas d'une excitation par effet Joule, ou une puissance lumineuse d'environ 20mW dans le cas d'une excitation par effet photothermique, si la fréquence du signal d'excitation correspond à la fréquence de résonance du mode de flexion du cristal.

Les moyens d'excitation de résonateurs à cristal non piézoélectrique décrits précédemment dans le cas du mode de flexion peuvent de la même manière être appliqués à l'excitation d'autres modes, notamment extension, mode de contour, cisaillement.

## Revendications

1. Résonateur à matériau non piézoélectrique à grand coefficient de qualité,
caractérisé en ce qu'il comprend un monocristal (11) d'un matériau non piézoélectrique présentant une faible atténuation des ondes élastiques de volume, des moyens de support (12 à 15) du monocristal fixés sur ce dernier en des points correspondant à des noeuds de vibration, des moyens thermiques (30⩾) pour provoquer directement une excitation propre du monocristal (11), et des moyens optiques (5 à 7; 50) pour détecter sans contact, les déplacements périodiques du résonateur.

2. Résonateur selon la revendication 1, caractérisé en ce que le monocristal (11) présente la forme d'un bâtonnet vibrant en flexion.

3. Résonateur selon la revendication 1 ou la revendication 2, caractérisé en ce que les moyens optiques (5 à 7) de détection des déplacements périodiques du résonateur comprennent une source de lumière (1) émettant un faisceau (3), une première lentille (4) pour faire converger le faisceau (3) vers une partie vibrante (110) du monocristal (11) perpendiculairement à la direction des vibrations, une seconde lentille (5) recevant le faisceau (3') affecté par le mouvement du monocristal (11) et un photodétecteur (6), de manière à assurer la détection des vibrations du résonateur.

4. Résonateur selon la revendication 1 ou la revendication 2, caractérisé en ce que les moyens optiques (50) de détection des déplacements périodiques du résonateur comprennent un dispositif interférométrique (52) associé à un analyseur de spectre (53) le faisceau du dispositif interférométrique (52) étant appliqué à la partie vibrante (110) du cristal (11), parallèlement à la direction des vibrations de celui-ci.

5. Résonateur selon l'une quelconque des revendications 1 à 4, caractérisé en ce qu'au moins une mince couche (30) d'un matériau conducteur est déposée sous forme de ruban sur une face du monocristal (11), des fils de connexion (22,23) sont raccordés à ladite couche (30) au niveau de noeuds de vibration du cristal, et une tension électrique périodique est appliquée entre lesdits fils de connexion (22,23) pour réaliser une excitation du cristal par effet thermique Joule.

6. Résonateur selon la revendication 5, caractérisé en ce que lacouche conductrice est constituée par une mince couche d'un métal tel que le chrome ou le nickel, déposée par évaporation sous vide ou par pulvérisation cathodique.

7. Résonateur selon la revendication 5 ou 6, caractérisé en ce que la tension électrique périodique d'excitation (v) oscille en permanence entre une valeur crête et zéro, afin d'exciter le cristal à la fréquence fondamentale du signal électrique.

8. Résonateur selon l'une quelconque des revendications 1 à 4, caractérisé en ce que les moyens (40) provoquant directement une excitation propre du monocristal (11) comprennent une source de lumière (41) et des moyens de modulation (42) auxquels est appliquée une tension de modulation $v_m$, pour appliquer un faisceau lumineux dont l'intensité est modulée dans une zone de vibration (111) du cristal et assurer une excitation propre du cristal (11) par effet photothermique.

9. Résonateur selon la revendication 8, caractérisé en ce qu'une couche absorbante (45) est déposée sur une face du monocristal (11) dans la zone frappée par ledit faisceau lumineux modulé (2).

10. Résonateur selon l'une quelconque des revendications 1 à 9, caractérisé en ce que le monocristal (11) est placé dans une ampoule de verre (20) à l'intérieur de laquelle la pression a été abaissée.

11. Résonateur selon l'une quelconque des revendications 1 à 10, caractérisé en ce que le monocristal (11) est un monocristal d'alumine.

12. Résonateur selon l'une quelconque des revendications 1 à 10, caractérisé en ce que le monocristal (11) est un cristal du type YAG ou YIG.

13. Oscillateur, caractérisé en ce qu'il comprend un résonateur à matériau non piézoélectrique à grand coefficient de qualité selon l'une quelconque des revendications 1 à 12, et en ce que la tension électrique de modulation appliquée aux moyens (30⩾) provoquant directement une excitation propre du cristal (11) est fournie par un amplificateur (9) recevant le signal de sortie des moyens optiques (5 à 7) de détection des déplacements périodiques du résonateur.

## Patentansprüche

1. Resonator aus nicht-piezoelektrischem Material, mit hohem Gütegrad, dadurch gekennzeichnet, daß er aus einem Einkristall (11) aus nicht-piezoelektrischem Material mit geringer Dämpfung der elastischen Volumenwellen, aus Halterungen (12 bis 15), die auf dem Einkristall lagemäßig an Schwingungsknotenpunkten angeordnet sind, aus thermischen Mitteln (30, 40) zur unmittelbaren Erzeugung einer Selbsterregung des Einkristalles (11), sowie aus optischen Mitteln (5 bis 7, 50) für die berührungslose Erfassung der periodischen Bewegungen des Resonators besteht.

2. Resonator nach Anspruch 1, dadurch gekennzeichnet, daß der Einkristall (11) aus einem in Biegerichtung schwingenden Stäbchen besteht.

3. Resonator nach Anspruch 1 oder 2, dadurch gekennzeichnet, daß die optischen Mittel (5 bis 7) zur Erfassung der periodischen Bewegungen des Resonators aus einer Lichtquelle (1) zur Erzeugung eines Lichtstrahles (3), einer ersten Linse (4) zur Fokussierung des Strahles (3) auf einen schwingenden Teil (110) des Einkristalls (11), dies senkrecht zur Schwingungsrichtung, einer zweiten Linse (5), die den durch die Schwingungen des Einkristalls beeinflußten Strahl (3') empfängt, sowie aus einem Photoempfänger (6) bestehen, um die Erfassung der Schwingungen des Resonators zu ermöglichen.

4. Resonator nach Anspruch 1 oder 2, dadurch gekennzeichnet, daß die optischen Mittel (50) zur Erfassung der periodischen Bewegungen des Resonators eine mit einem Spektrumanalysator (53) vereinigte Interferenzmeßvorrichtung (52) beeinhalten, wobei der Lichtstrahl der Interferenzmeßvorrichtung (52) dem schwierigen Teil (110) des Kristalls (11) parallel zu dessen Schwingungsrichtung angelegt wird.

5. Resonator nach einem beliebigen Anspruch 1 bis 4, dadurch gekennzeichnet, daß mindestens eine dünne Schicht (30) eines leitendes Material in Form eines Bandes auf einer Seite des Einkristalls (11) aufgebracht wird, Verbindungsleitungen (22, 23) auf die genannte Schicht auf Höhe von Schwingungsknotenpunkten angelötet werden und daß eine periodische elektrische Spannung zwischen den genannten Verbindungsleitungen (22, 23) angelegt wird, damit der Kristall durch Joule-Effekt erregt wird.

6. Resonator nach Anspruch 5, dadurch gekennzeichnet, daß die leitende Schicht aus einer dünnen Metallschicht, wie z.B. Chrom oder Nickel, besteht, die durch Vakuumverdampfung oder Kathodenzerstäubung aufgebracht wird.

7. Resonator nach Anspruch 5 und 6, dadurch gekennzeichnet, daß die periodische, elektrische Erregungsspannung (v) zwischen einem Spitzenwert und dem Nullwert schwingt, damit der Kristall mit der Grundfrequenz des elektrischen Signals erregt wird.

8. Resonator nach einem beliebigen Anspruch 1 bis 4, dadurch gekennzeichnet, daß die Mittel (40) zur unmittelbaren Erzeugung der Eigenschwingung des Einkristalles (11) aus einer Lichtquelle (41) sowie aus einer mit einer Modulationsspannung $v_m$ erregten Modulationsmitteln (42) bestehen, damit ein Lichtstrahl mit entsprechend modulierter Stärke auf eine Schwingungszone (111) des Kristalls angelegt werden kann und eine Eigenschwingung des Kristalls (11) durch photothermischen Effekt bewirkt wird.

9. Resonator nach Anspruch 8, dadurch gekennzeichnet, daß eine lichtabsorbierende Schicht (45) auf eine Seite des Einkristalls (11) aufgebracht wird, und zwar in der Zone auf welche der genannte modulierte Lichtstrahl (1) angelegt wird.

10. Resonator nach einem beliebigen Anspruch 1 bis 9, dadurch gekennzeichnet, daß der Einkristall (11) in einem Glaskolben (20) eingefaßt ist, in welchem der Gasdruck herabgesetzt worden ist.

11. Resonator nach einem beliebigen Anspruch 1 bis 10, dadurch gekennzeichnet, daß der Einkristall (11) aus einem Aluminiumoxyd-Einkristall besteht.

12. Resonator nach einem beliebigen Anspruch 1 bis 10, dadurch gekennzeichnet, daß der Einkristall (11) aus einem Kristall des YAG- oder YIG-Types besteht.

13. Oszillator, dadurch gekennzeichnet, daß er aus einem Resonator aus nicht piezoelektrischem Material mit hohem Gütegrad nach einem beliebigen Anspruch 1 bis 12 besteht, und daß die den Mitteln (30, 40) angelegte, elektrische Modulationsspannung zur Bewirkung der Eigenschwingung des Kristalls (11) durch einen Verstärker (9) erzeugt wird, der das Ausgangssignal der optischen Mittel (3 bis 7) zur Erfassung der periodischen Bewegungen des Resonators verarbeitet.

**Claims**

1. Resonator of nonpiezoelectric material with a high quality coefficient caracterised in that it comprises a monocrystal (11) of nonpiezoelectrical material with a low attenuation of bulk elastic waves, means for (12 to 15) supporting the monocrystal at points corresponding to vibration nodes, thermal means (30, 40) for directly causing an excitation of the monocrystal (111) at its natural frequency and optical means (5 to 7; 50) for detecting periodic motions of the resonator, without contact with said resonator.

2. Resonator as claimed in claim 1, wherein said monocrystal (11) has the form of a rod vibrating in a bending mode.

3. Resonator as claimed in claim 1 or 2 wherein said optical means (5 to 7) for detecting the periodic motions of the resonator comprise a light source (1) emetting a beam (3) a first lens (4) to converge the beam (3) onto the vibrating part (110) of the monocrystal (11) perpendicular to the direction of the vibrations, a second lens (5) receiving the beam (3) affected by the motion of the monocrystal (11) and a photodectector (6) to detect the vibrations of the resonator.

4. Resonator according to claim 1 or 2, wherein said optical means (50) of detecting the periodic motions of said resonator comprise an interferometric device (52) associated with a spectrum analyzer (53) the beam of the interferometric device (52) being applied to the vibrating part (10) of the crystal (11) parallel to the direction of crystal vibration.

5. Resonator according to any of claims 1 to 4, wherein at least a thin layer (30) of conductive material is deposited in the form of tape on a face of the monocrystal (11), connection wires (22, 23) being connected to said layer (30) at the crystal vibration nodes, and a periodic electrical voltage being applied between the connection wires (22, 23) to excite the crystal by Joule effect.

6. Resonator as claimed in claim 5, wherein the conductive layer consists of a thin layer of a metal such as chromium or nickel, desposited by vacuum evaporation or a cathode sputtering.

7. Resonator according to claim 5 or 6, wherein the periodic electrical voltage (v) oscillates continuously between a peak value and zero, in order to excite the crystal at a fundamental frequency of the electrical signal.

8. Resonator according to any of claims 1 to 4, wherein said means (40) directly causing an excitation of the monocrystal (11) at its natural frequency include a light source (41) and modulation means (42) to which is applied a modulation voltage v to apply a light beam with modulated intensity in a vibration zone (111) of the crystal and to ensure an excitation of the crystal at its natural frequency by photothermal effect.

9. Resonator as claimed in claim 8, wherein an absorbing layer (45) is deposited on a face of said monocrystal (11) in an area receiving the incident modulated light beam (2).

10. Resonator as claimed in any one of claims 1 to 9, wherein the monocrystal (11) is enclosed in a glass bulb (20) with reduced pressure inside.

11. Resonator as claimed in any one of claims 1 to 10, wherein the monocrystal is made of alumina.

12. Resonator as claimed in any one of claims 1 to 10, wherein the monocrystal is of the YAG or YIG type.

13. Oscillator, wherein the oscillator includes a resonator of nonpiezoelectric material with high quality coefficient as claimed in any one of claims 1 to 12, and wherein the electrical modulation voltage applied to the thermal means (30, 40) directly causing an excitation of the crystal (11) at its natural frequency is supplied by an amplifier (9) receiving the output signal from said optical means (5 to 7) of detection of the resonator periodic motions.

Fig-1

Fig-5

Fig-2

Raies de la vibration

f

53 50 52 51 110 10 45 111 11 2 44 42 43 $v_m$ 40 41

Fig-3

7 6 8 9 5 12 30 13 110 4 15 14 1 3

Fig-4